**Europäisches Patentamt**

**European Patent Office**

**Office européen des brevets**

(19)

(11) **EP 1 369 911 A1**

(12) **EUROPEAN PATENT APPLICATION**
published in accordance with Art. 158(3) EPC

(43) Date of publication:
**10.12.2003 Bulletin 2003/50**

(51) Int Cl.7: **H01L 21/60**

(21) Application number: **02702876.0**

(22) Date of filing: **11.03.2002**

(86) International application number:
**PCT/JP02/02255**

(87) International publication number:
**WO 02/073686 (19.09.2002 Gazette 2002/38)**

(84) Designated Contracting States:
**AT BE CH CY DE DK ES FI FR GB GR IE IT LI LU MC NL PT SE TR**

(30) Priority: **12.03.2001 JP 2001068376**

(71) Applicant: **Sony Corporation
Tokyo 141-0001 (JP)**

(72) Inventor: **YOSHIDA, Koji,
c/o SONY EMCS CORP. KISARAZU TEC
Kisarazu-shi, Chiba 292-0834 (JP)**

(74) Representative: **Thévenet, Jean-Bruno et al
Cabinet Beau de Loménie
158, rue de l'Université
75340 Paris Cédex 07 (FR)**

(54) **METHOD OF MANUFACTURING SEMICONDUCTOR DEVICE**

(57) There is provided a method of fabricating a semiconductor device wherein a package is sealed appropriately and with ease using an under-fill resin, a desirable fillet shape is realized, and a highly reliable flip-chip package may be obtained even while employing the ultrasonic bonding method. The present method of fabricating a semiconductor device comprises a first step for forming an under-fill resin layer (16) on a circuit board (10) so as to cover a wiring pattern (12), a second step for mutually bonding the wiring pattern (12) and a protruding electrode (24) by positioning a semiconductor chip (20) having the protruding electrode (24) above and in opposition with the wiring pattern (12) of the circuit board (10), and further by applying ultrasonic vibration to the semiconductor chip (20) while pressing the protruding electrode (24) against the wiring pattern (12) and penetrating the under-fill resin layer (16), and a third step for curing the under-fill resin layer (16) interposed between the circuit board (10) and the semiconductor chip (20).

Fig.2B

**Description**

TECHNICAL FIELD

The present invention relates to a method of fabricating a semiconductor device, and more specifically to a method of fabricating a semiconductor device suitable for use in connecting a bonding pad of a flip-chip-type semiconductor chip to a circuit board.

BACKGROUND ART

In recent years, interest in employing the ultrasonic bonding method in making a flip-chip package by bonding a semiconductor chip to a circuit board mechanically and electrically has been growing. Descriptions of the ultrasonic bonding method are present in, for example, Japanese Laid-Open Patent Publication No. HEI-10-50758 and Japanese Laid-Open Patent Publication No. 2000-195905.

It is also known that, in the making of a flip-chip package, damages resulting from the discrepancy between the thermal expansion coefficients of a semiconductor chip and a circuit board is prevented by injecting and curing an under-fill resin between the semiconductor chip and the circuit board.

However, in Japanese Laid-Open Patent Publication No. HEI-10-50758, only contents related to an outline of an apparatus employed in the ultrasonic bonding method are mainly described, and there is no description of a process for injecting an under-fill resin into a gap between a circuit board and a connected semiconductor chip. Further, in Japanese Laid-Open Patent Publication No. 2000-195905, only contents related to the cleaning of a tool head of an ultrasonic bonding apparatus are mainly described, and there is no description on the injection of under-fill resin.

In other words, despite the fact that interest in using the ultrasonic bonding method in the fabrication of flip-chip packages has been growing, what can be fabricated with current technology is limited to packages in which the injection of resin is unnecessary owing to the use of ceramic boards, packages with few pins and of a small chip, and which do not require reinforcement by resin injection, and the like.

Incidentally, in applying the ultrasonic bonding method to a semiconductor chip of a larger chip or a semiconductor chip with more pins, injecting an under-fill resin after the bonding of the semiconductor chip and the circuit board is necessary, however, in that case, the occurrence of the following problems is conceivable.

In other words, after the bonding of the semiconductor chip and the circuit board, in order to inject the under-fill resin between both, a device called a dispenser must be employed. However, in employing a dispenser, control of an appropriate resin injection amount is difficult, and it is difficult to inject the appropriate amount of resin continuously.

In addition, because the injection of the under-fill resin carried out by invading the space between the semiconductor chip and the circuit board by making use of the capillary phenomenon, it is difficult to seal the space between both the semiconductor chip and the circuit board with the under-fill resin in an appropriate state. In this case, obtaining a desirable fillet shape sloping down gently from the outer edge of the semiconductor chip is difficult.

For this reason, there exists a possibility that the reliability of the package may be lowered such that the stress resulting from the discrepancy between the thermal expansion coefficients of the semiconductor chip and the circuit board cannot be absorbed effectively, that desirable conduction performance is impaired, and so forth.

As such, an object of the present invention is to provide a method of fabricating a semiconductor device wherein the gap between a semiconductor chip and a circuit board is sealed with an under-fill resin properly and with ease, a desirable fillet shape is realized, and a highly reliable flip-chip package having good conduction performance may be obtained, even while employing the ultrasonic bonding method.

DISCLOSURE OF THE INVENTION

To accomplish the object mentioned above, the method of fabricating a semiconductor device according to the present invention is characterized in that it comprises a first step for forming an under-fill resin layer on a circuit board on which a wiring pattern is formed so as to cover at least a part of the wiring pattern,

a second step for mutually bonding a wiring pattern and a protruding electrode mechanically and electrically by positioning the bonding pad and a semiconductor chip having the protruding electrode formed on the bonding pad above and in opposition with the wiring pattern of the circuit board, and further by applying ultrasonic vibration to the semiconductor chip while pressing the protruding electrode against the wiring pattern and penetrating the under-fill resin layer, and

a third step for administering a predetermined treatment to the circuit board and the semiconductor chip in which the wiring pattern and the protruding electrode are bonded, and curing the under-fill resin mediating the circuit board and the semiconductor chip.

According to the method of fabricating a semiconductor device of the present invention, because the under-fill resin layer is formed and ultrasonic bonding may be carried out before the curing thereof, package sealing may be done by interposing the under-fill in the gap between the semiconductor chip and the circuit board appropriately and with ease, even while employing the ultrasonic bonding method.

Ordinarily, insulative particles called fillers are mixed in the under-fill resin in order to bring the linear expansion coefficients of the semiconductor chip and the resin closer, and with other pressure bonding methods using resin which differ from the ultrasonic bonding method, for example, there are reports that bad connections occur in cases where the filler is caught between the electrodes.

However, in the fabrication method of the present invention, because ultrasonic vibration is applied to the semiconductor chip while pressing the protruding electrode against the wiring pattern from above the under-fill resin layer, it is possible to bond both sides while pushing out the fillers in the under-fill resin layer from between the protruding electrode and the wiring pattern with ultrasonic vibration.

During this bonding, if, for example, a gel-like resin is used for the under-fill resin layer, by virtue of the fact that ultrasonic vibration propagates to various sections of the gel-like resin, it is possible to obtain a desirable fillet shape where the part which falls outside of the outer edge of the semiconductor chip naturally slopes down towards the circuit board. On the other hand, in a case where, for example, an under-fill resin film is used for the under-fill resin layer, it is possible to shrink and cure the end portion of the resin which falls outside of the outer edge of the semiconductor chip and to obtain a desirable fillet shape by taking a thermal treatment as the predetermined treatment in the third step.

For this reason, despite the fact that the protruding electrode and the wiring pattern are bond processed after the under-fill resin layer is formed on the wiring pattern in advance, both can be bonded mechanically and electrically with desirable conduction performance. In addition, it is possible to obtain a highly reliable flip-chip package, which is capable of appropriately absorbing the stress at work between the semiconductor chip and the circuit board, and which has good conduction performance.

In a preferable mode for carrying out the present invention, a gel-like resin having insulative properties as well as thermo-setting properties is applied as the under-fill layer on the wiring pattern in the first step, and the gel-like resin is cured through a thermal treatment under a predetermined temperature (140 °C ~ 160 °C, for example) in the third step.

For the gel-like resin, "CV5186" (product number) produced by Matsushita Electric Works, Ltd. may be given as an example.

In applying the gel-like resin, a dispensing method or a printing method may be employed. For example, in employing the dispensing method, because the application of resin is performed prior to the second step (initial bonding) in a semiconductor assembling step employing the ultrasonic bonding method, there are advantages in that a fine resin application process becomes unnecessary and operations become simple.

On the other hand, if the printing method is employed, there is no need to use a device such as a dispenser in addition. For this reason, it is possible to get rid of problems such as not being able to obtain good sealing conditions resulting from the dispensing amount not being appropriate.

According to the present invention, by employing both the dispensing method and the printing method, it becomes possible to simplify the resin-sealing step by the ultrasonic bonding method, and it becomes possible to resolve process faults.

In a further preferable mode for carrying out the present invention, a resin film having insulative properties as well as thermo-setting properties is adhered on the wiring pattern as the under-fill resin layer in the first step, and the resin film is cured through a thermal treatment under a predetermined temperature (140 °C ~ 160 °C, for example) in the third step.

In this case, because the under-fill resin layer can readily and appropriately be formed by simply adhering the resin film prior to the second step (initial bonding), process faults may be resolved while eliminating cumbersome steps such as fine resin application and the like, and further process simplification may be realized.

For the film-like resin, there may be used an under-fill resin film in which particles of silicon dioxide (silica) and/or aluminum oxide (alumina) or the like having thermal expansion coefficients close to the thermal expansion coefficient of the semiconductor chip are mixed.

For the under-fill resin film, "PFM21-B1F" (product number) produced by Nitto Denko Corporation may be given as an example.

BRIEF DESCRIPTION OF THE DRAWINGS

Fig. 1 is a flow chart showing a method of fabricating a semiconductor device according to Exemplary Mode 1 of the present invention;

Fig. 2A through Fig. 2D are side views showing respective steps corresponding to FIG. 1;

Fig. 3A through Fig. 3C are plan views showing application methods of a gel-like resin by the dispensing method, and each shows a single-spot, four-spot, and five-spot application method, respectively;

Fig. 4A through Fig. 4C are side views showing shapes of the protruding electrode which may be used in the present invention, and respectively show differing leveling shapes;

Fig. 5A through Fig. 5C are side views showing steps for bonding a protruding electrode and a wiring pattern according to Exemplary Mode 1, and each shows a different stage;

Fig. 6A through Fig. 6F are side views showing a resin application step in stages by the printing method;

Fig. 7 is a flowchart showing a method of fabricating a semiconductor device according to Exemplary Mode 2 of the present invention;

Fig. 8A through Fig. 8F are side views showing the respective steps corresponding to Fig. 7;

Figs. 9A through Fig. 9D are side views showing the respective steps corresponding to Fig. 7; and

Fig. 10A through Fig. 10C are side views showing a step for bonding the protruding electrode and wiring pattern according to Exemplary Mode 2, and each shows a different stage.

BEST MODES FOR CARRYING OUT THE INVENTION

Below, modes for carrying out the present invention will be described specifically and in detail with reference to the accompanying drawings by citing exemplary modes.

Exemplary Mode 1

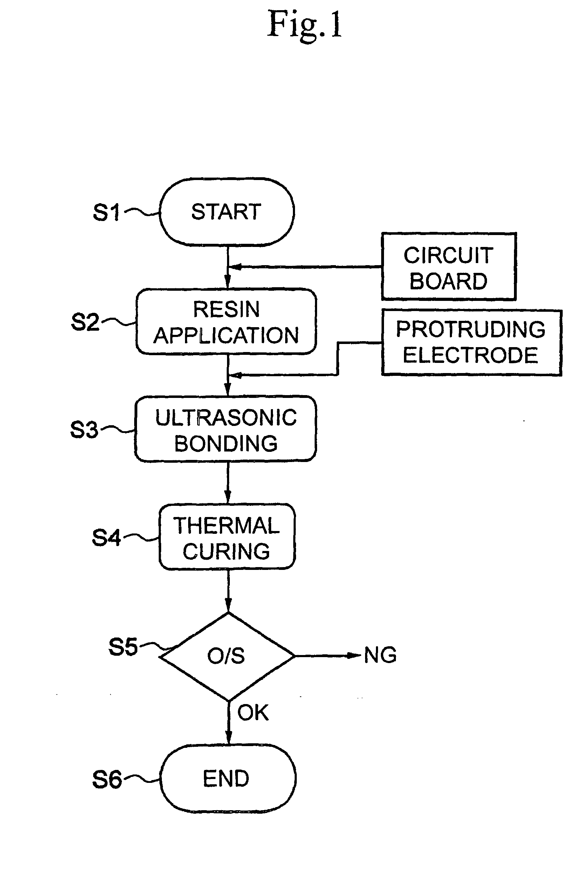

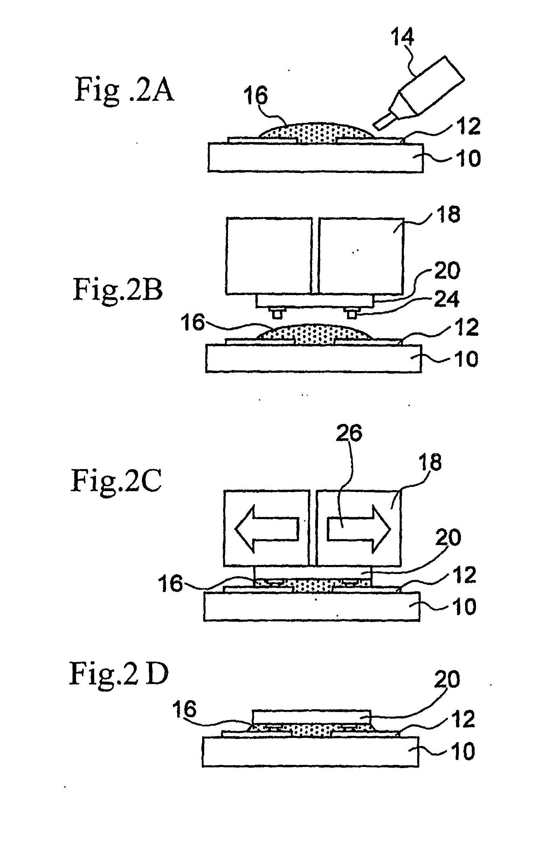

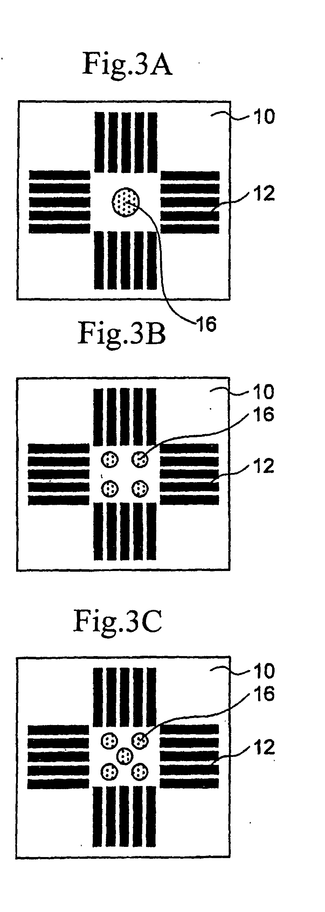

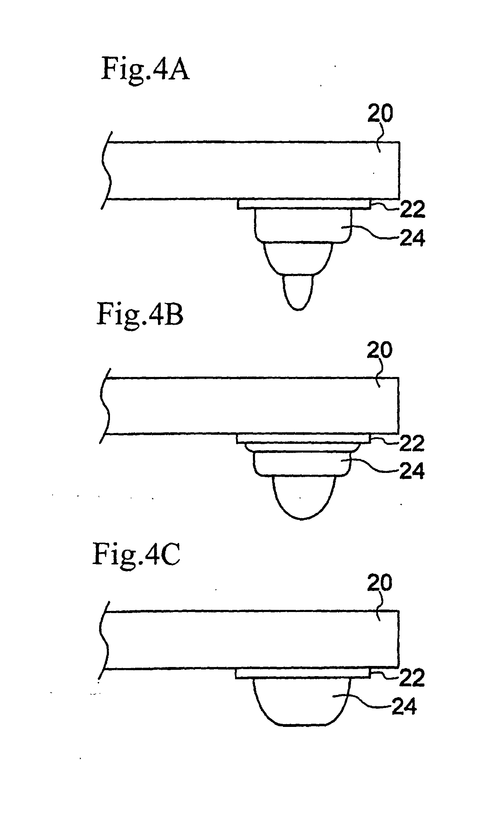

This exemplary mode is one example of a mode of the method of fabricating a semiconductor device according to the present invention, where Fig. 1 is a flowchart showing a method of fabricating a semiconductor device according to the present exemplary mode, Fig. 2A through Fig. 2D are side views showing the respective steps corresponding to Fig. 1, Fig. 3A through Fig. 3C are plan views showing application methods for a gel-like resin by the dispensing method, and Fig. 4A through Fig. 4C are side views showing the shapes of a protruding electrode which may be employed in the present exemplary mode. In addition, in Fig. 2A through Fig. 2D and Fig. 4A through Fig. 4C, only two or one of the protruding electrodes, of which there are many, are shown.

First, as shown in Fig. 1, ultrasonic bonding is started in step S1 and an under-fill resin layer, that is, a gel-like resin 16, is applied on a wiring pattern (lead wiring) 12 of a circuit board 10 using a resin application syringe 14 by the dispensing method (Fig. 2A).

This application step is capable of application centering around one spot in the center section of the circuit board as shown in Fig. 3A, of application on four spots respectively in the center section of the circuit board as shown in Fig. 3B, and of application on five spots respectively in the center portion of the circuit board as shown in Fig. 3C.

In the dispensing method, because the resin application syringe 14 filled with the gel-like resin 16 is controlled by air pressure, not only the one to five-spot application mentioned above, but application to further numerous multi-spots may be adopted, and a selection can be made arbitrarily from the respective application methods depending on the layout of the lead wiring 12.

Next, in step S3, a protruding electrode 24 on a bonding pad 22 of a semiconductor chip 20 (see Fig. 4A through Fig. 4C) mounted on an ultrasonic bonder head 18 is positioned in opposition with the wiring pattern 12 (Fig. 2B).

Here, a plurality of bonding pads 22 made of aluminum are formed on the lower surface of the semiconductor chip 20, and to each bonding pad 22 is electrically and mechanically bonded the protruding electrode 24.

For the protruding electrode 24, for example, a shape to which no leveling is done at all as shown in Fig. 4A, a shape to which leveling is done with a relatively low load as shown in Fig. 4B, and a shape to which leveling is done with a relatively high load as shown in Fig. 4C may be employed. The type shown in Fig. 4C is an electrode shape ordinarily used in ACF bonding or the like, and the peak end portion of the protruding electrode 24 takes on a more planar shape compared to those of the other types in order to secure a larger area.

The protruding electrodes 24 of each shape is configured as a stud bump using a gold (Au) wire so that it is crushed and deformed with ease with the initial load during ultrasonic bonding.

In addition, in the present exemplary mode, that shown in Fig. 4B is employed, because the peak ends of the protruding electrodes 24 can be brought into contact with the wiring pattern 12 simultaneously with the initial load during ultrasonic bonding.

Next, ultrasonic vibration is applied from the ultrasonic bonder head 18 to the semiconductor chip 20 while pressing the protruding electrode 24 of the semiconductor chip 20 against the wiring pattern 12 of the circuit board 10 with a predetermined pressure using the ultrasonic bonder head 18 (Fig. 2C).

In so doing, because the protruding electrode 24 rubs against the wiring pattern 12 in a pressurized state due to ultrasonic vibration in the directions indicated by arrows 26, the protruding electrode 24 and the wiring pattern 12 mechanically and electrically bond with each other (Fig. 2D).

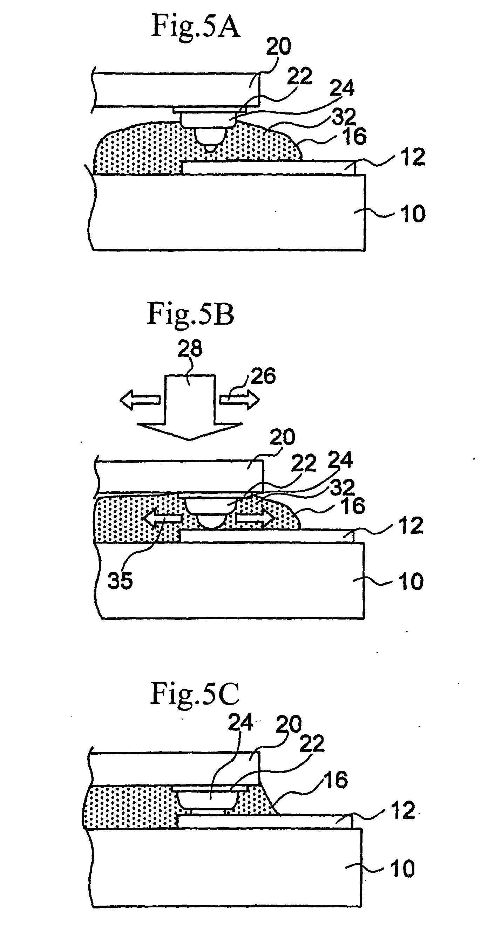

Here, the state of the protruding electrode 24 and the wiring pattern 12 at bonding are shown in Fig. 5A through Fig. 5C.

More specifically, as shown Fig. 5A, the gel-like resin 16 is penetrated by pressing the protruding electrode 24 against the wiring pattern 12 from above the gel-like resin 16, and the peak end portion of the protruding electrode 24 is brought into contact with the wiring pattern 12.

Further, as shown in Fig. 5B, ultrasonic vibration in the directions of the arrows 26 is applied to the semiconductor chip 20 while pressing the semiconductor chip 20, in other words the protruding electrode 24, in the direction indicated by an arrow 28. As a result, the protruding electrode 24, whose peak end portion is crushed and deformed, vibrates in the directions indicated by arrows 35 and pushes out a filler 32 in the gel-like resin 16 from the space between the wiring pattern 12 and itself, and bonds with the wiring pattern 12 as shown in Fig. 5C.

At the same time, by virtue of the propagation of ultrasonic vibration to various portions of the gel-like resin 16, a desirable fillet shape shown in Fig. 5C, where the portion which falls outside of the outer edge of the semiconductor chip 20 naturally slopes down towards the circuit board 10, may be obtained. In contrast thereto, if, for example, the gel-like resin 16 is provided around the bonded portion after the protruding electrode 24 and the wiring pattern 12 are bonded, there arise problems such as not being able to obtain a desirable fillet shape, or the like.

Subsequently, in step S4, the bonded semiconductor chip 20 and the circuit board 10 are housed in a predetermined chamber, and the gel-like resin 16 is cured by performing a thermal treatment (thermal curing) under a temperature of, for example, 140 °C ~ 160 °C for 110 minutes ~ 130 minutes.

Then, in step S5, an inspection on conduction performance and the like of the semiconductor chip 20 and the circuit board 10, which have formed a package by virtue of the curing of the gel-like resin 16 is conducted. If, as a result, it is judged acceptable, the process is terminated with that package taken as an acceptable product (step S6). On the other hand, if it is judged defective, that package is to be recalled as a defective product.

Thus, both the protruding electrode 24 and the circuit board 12 may be mechanically and electrically bonded to have good conduction performance even while the protruding electrode 24 and the wiring pattern 12 are bonded after the gel-like resin is applied on the wiring pattern 12 in advance.

Further, a highly reliable flip-chip package having good conduction performance, which is capable of appropriately absorbing the stress at work between the semiconductor chip 20 and the circuit board 10, may be obtained.

Although in the present exemplary mode, an example in which the dispensing method is employed for the forming process for the under-fill resin layer prior to ultrasonic bonding was given, it is not limited thereto, and the printing method may also be employed.

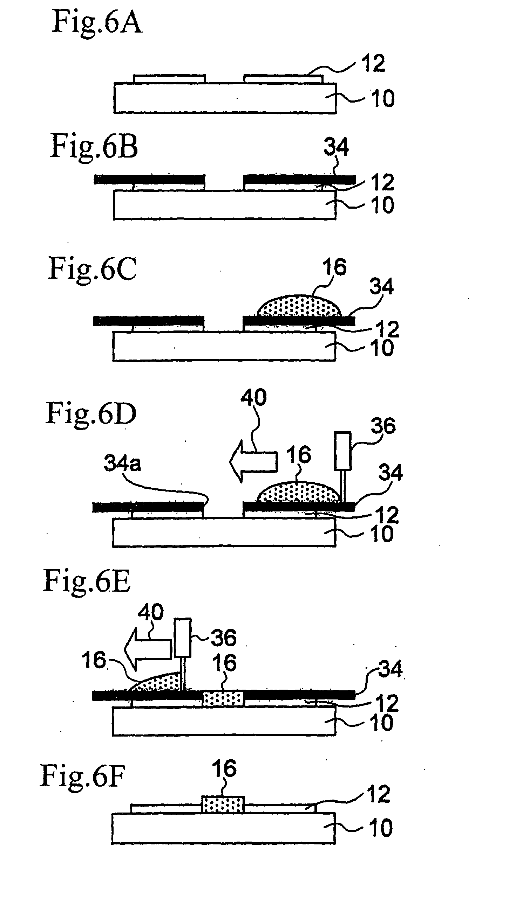

Fig. 6A through Fig. 6F are views showing, in stages, the application step for the gel-like resin 16 by the printing method.

First, as shown in Fig. 6A, the circuit board 10 is prepared, the wiring pattern 12 is covered with a printing screen 34 as shown in Fig. 6B, and the gel-like resin 16 is placed on one end side of the printing screen 34 as shown in Fig. 6C.

In this state, a printing squeegee 36 is moved in a parallel manner in the direction indicated by an arrow 40 as shown in Fig. 6D. As a result, the gel-like resin 16 evenly enters an opening 34a of the printing screen 34 as shown in Fig. 6E.

Further, by removing the printing screen 34, the gel-like resin 16 of a predetermined thickness is formed at a predetermined position in the wiring pattern 12 as shown in Fig. 6F.

In the printing method described above, unlike in the dispensing method, the resin application amount does not become unstable due changes in the control air pressure of the resin application syringe 14 according to the amount of resin remaining in the syringe, and the amount applied on the wiring pattern 12 may be controlled with certainty. Thus, controlling the resin application upon entering mass-production becomes much easier.

Exemplary Mode 2

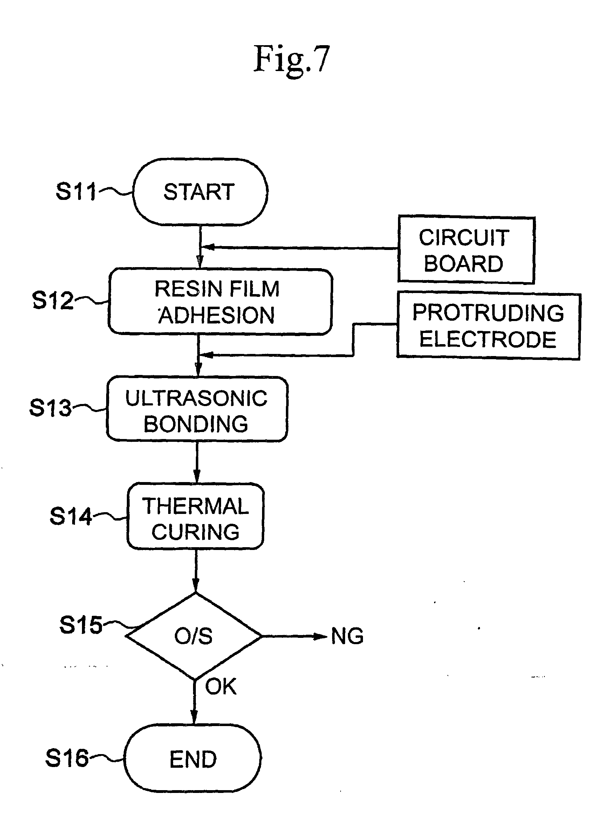

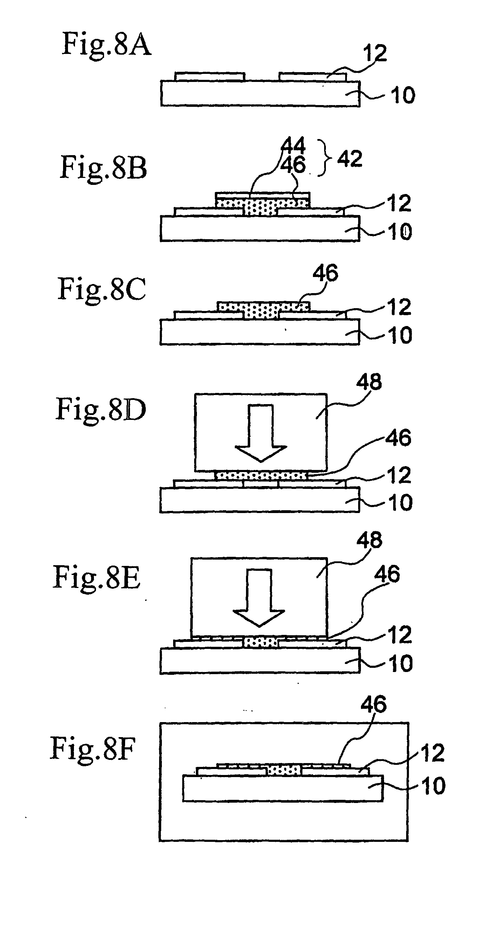

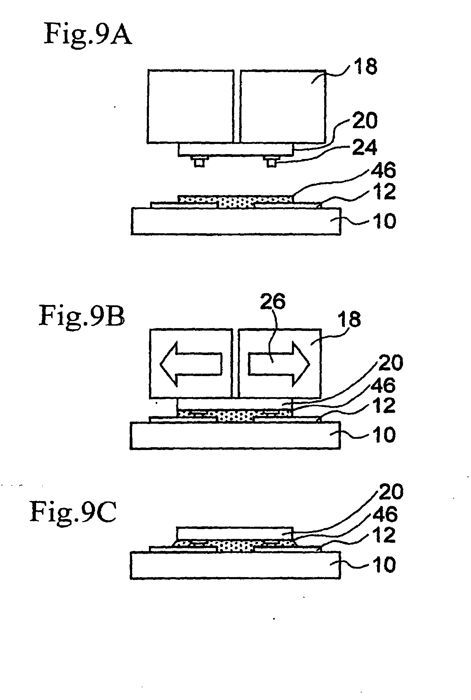

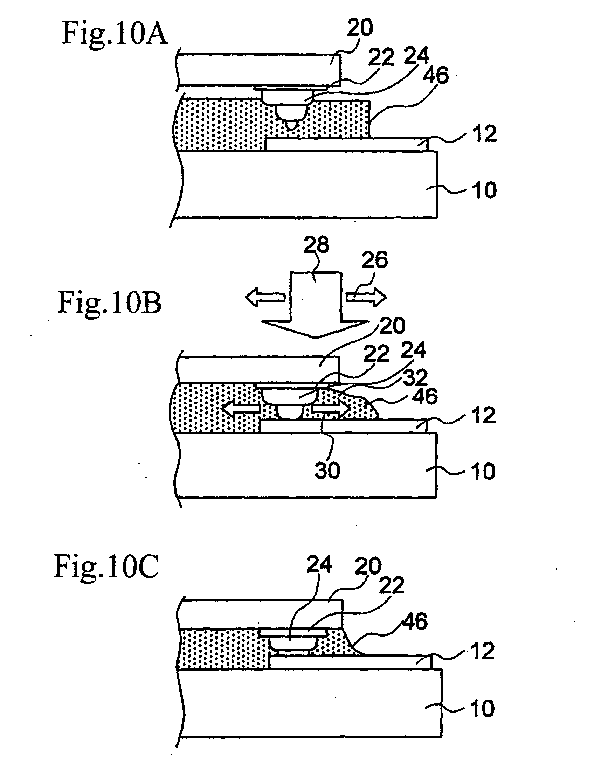

This exemplary mode is another mode of the method of fabricating a semiconductor device according to the present invention, and Fig. 7 is a flowchart showing a method of fabricating a semiconductor device according to the present exemplary mode, Fig. 8A through Fig. 8F and Fig. 9A through Fig. 9D are side views showing the respective steps corresponding to Fig. 7, and Fig. 10A through Fig. 10C are side views showing, in stages, the process up to where the protruding electrode bonds with the wiring pattern.

First, as shown in Fig. 7, the ultrasonic bonding method is started (step S1), a circuit board 10 is prepared (Fig. 8A), and an under-fill resin layer, that is, an under-fill resin film 42 is adhered on a wiring pattern 12 on the circuit board 10 (Fig. 8B).

The under-fill resin film 42 comprises a separator section 44 and an adhesive layer 46 for the purpose of improving ease of handling. Therefore, first, after adhering the adhesive layer 46 of the under-fill resin film 42 so as to cover at least a part of the wiring pattern 12 on the circuit board 10, the separator portion 44 is removed (Fig. 8C). As a result, the adhesive layer 46 remains on the wiring pattern 12 of the circuit board 10.

In this case, since the thickness of the adhesive layer 46 on the wiring pattern 12 can be altered as deemed appropriate depending on the thickness of the under-fill resin film 42 to be used, the process becomes simpler compared to the method in which the gel-like resin 16 is applied in a predetermined thickness by the printing method.

Next in order to improve the adhesiveness of the adhesive layer 46, the adhesive layer 46 is settled on the wiring pattern 12 in a planar form by applying a predetermined load on the adhesive layer 46 with a head section 48 of a tacking apparatus as shown in Fig. 8D and Fig. 8E.

Thereafter, as shown in Fig. 8F, a thermal treatment of, for example, approximately 10 seconds under a temperature of 100 °C is performed, and the adhesive layer 46 is first fused before being cured to a predetermined hardness (tentative curing).

Then, in step S13, ultrasonic bonding is carried out. More specifically, the semiconductor chip 20 is positioned in opposition with the adhesive layer 46 on the wiring pattern 12 by the ultrasonic bonder head 18 (Fig. 9A).

Further, ultrasonic vibration is applied from the ultrasonic bonder head 18 to the semiconductor chip 20 while pressing the protruding electrode 24 of the semiconductor chip 20 against the wiring pattern 12 with a predetermined pressure (Fig. 9B).

In so doing, because the protruding electrode 24 rubs against the wiring pattern in a pressurized state due to ultrasonic vibration in the directions indicated by arrows 26, the protruding electrode 24 and the wiring pattern 12 mechanically and electrically bond with each other (Fig. 9C).

Here, conditions of the protruding electrode 24 and the wiring pattern 12 during bonding are shown in Fig. 10A through Fig. 10C. In other words, as shown in Fig. 10A, the protruding electrode 24 is pressed against the wiring pattern 12 from above the adhesive layer 46 of the under-fill resin film 42, thereby penetrating the under-fill resin film 42, and bringing the peak end portion of the protruded electrode 24 into contact with the wiring pattern 12.

Further, as shown in Fig. 10B, ultrasonic vibration is applied to the semiconductor chip 20 in the directions indicated by arrows 26 while pressing the semiconductor chip 20, and therefore the protruding electrode 24, in the direction indicated by an arrow 28. As a result, the protruding electrode 24 whose peak end portion is crushed and deformed vibrates in the directions indicated by arrows 30, pushes out the filler 32 in the adhesive layer 46 from the space between the protruding electrode 24 and the wiring pattern 12, and bonds with the wiring pattern 12 (Fig. 10C).

Subsequently, in step S14, the adhesive layer 46 is completely cured (permanent curing) by administering a thermal treatment (thermal curing) under a temperature of 140 °C ~ 160 °C for approximately 110 to 130 minutes, for example. During this curing, the adhesive layer 46 takes on a desirable fillet shape naturally sloping down towards the circuit board 10 as shown in Fig. 10C by virtue of the shrinkage of a portion of the resin which falls outside of the outer edge portion of the semiconductor chip 20.

Then, in step S15, a screening for checking requisites such as conduction performance and the like is carried out, and if judged as being acceptable, the process is terminated (step S16), and if judged as being defective, that package is recalled as a defective product.

As has been described above, in Exemplary Modes 1 and 2 of the present invention, because it is possible to form the under-fill resin layer with the gel-like resin 16 or the under-fill resin film 42, and to perform ultrasonic bonding before the curing thereof, the under-fill resin can be interposed in the gap between the semiconductor chip 20 and the circuit board, and the package can be sealed appropriately and with ease even while employing the ultrasonic bonding method.

Moreover, since ultrasonic vibration is applied to the semiconductor chip 20 while pressing the protruding electrode 24 against the wiring pattern 12 from above the under-fill resin layer, both can be bonded while reliably pushing out the filler 32 in the under-fill resin layer from between the protruding electrode 24 and the wiring pattern 12 with ultrasonic vibration. Hence, both can be bonded with a desirable conduction performance although the bonding process comes after the formation of the under-fill resin layer on the wiring pattern 12. Thus, the stress at work between the semiconductor chip 20 and the circuit board 10 may be absorbed appropriately, and a highly reliable flip-chip package having desirable conduction performance may be obtained.

In addition, in Exemplary Modes 1 and 2, the protruding electrode 24 is formed as a stud bump using a gold (Au) wire, and the connection distance between the wiring pattern 12 is made extremely short. As a result, compared to the case where a semiconductor chip and a wiring pattern are connected through wire bonding, for example, a desirable conductive condition in which the impedance $Z_0$ indicated by

$$Z_0 = \{R^2+(\omega L\text{-}1/\omega c)^2\}^{1/2}$$

is significantly reduced may be obtained.

As is described above, according to the method of fabricating a semiconductor device of the present invention, the gap between a semiconductor chip and a circuit board is sealed appropriately and with ease using an under-fill resin while realizing a desirable fillet shape, and a highly reliable flip-chip package having good conduction performance, and which can appropriately absorb the stress at work between the semiconductor chip and the circuit board may be obtained even while employing the ultrasonic bonding method.

**Claims**

1. A method of fabricating a semiconductor device **characterized by** comprising a first step for forming on a circuit board having a wiring pattern formed thereon an under-fill resin layer so as to cover at least a part of the wiring pattern, a second step for bonding the wiring pattern and a protruding electrode with each other mechanically and electrically by positioning the semiconductor chip having a bonding pad and the protruding electrode formed on the bonding pad in opposition with the wiring pattern on the circuit board, and further applying ultrasonic vibration to the semiconductor chip while pressing the protruding electrode against the wiring pattern and penetrating the under-fill resin layer, and a third step for curing the under-fill resin interposed between the circuit board and the semiconductor chip by administering a predetermined treatment to the circuit board and the semiconductor chip in which the wiring pattern and the protruding electrode are bonded.

2. The method of fabricating a semiconductor device as claimed in Claim 1, **characterized in that** in the first step, a gel-like resin having insulative and thermosetting properties is applied on the wiring pattern as the under-fill resin layer, and in the third step, the gel-like resin is cured by a thermal treatment under a predetermined temperature.

3. The method of fabricating a semiconductor device as claimed in Claim 2, **characterized in that** in applying the gel-like resin, a dispensing method or a printing method is employed.

4. The method of fabricating a semiconductor device as claimed in Claim 1, **characterized in that** in the first step, a resin film having insulative and thermosetting properties is adhered on the wiring pattern as the under-fill resin layer, and in the third step, the resin film is cured by a thermal treatment under a predetermined temperature.

5. The method of fabricating a semiconductor device as claimed in Claim 4, wherein an under-fill resin film in which particles of silicon dioxide and/or aluminum oxide having thermal expansion coefficients close to a thermal expansion coefficient of the semiconductor chip are mixed is used as the resin film.

# Fig.1

```
  S1 ◠  ( START )

                              ┌──────────────┐
                              │   CIRCUIT    │
                              │    BOARD     │
                              └──────┬───────┘
  S2 ◠  ┌──────────────┐            │
        │    RESIN     │←───────────┘
        │ APPLICATION  │
        └──────┬───────┘     ┌──────────────┐
               │             │  PROTRUDING  │
               │←────────────│  ELECTRODE   │
  S3 ◠  ┌──────────────┐     └──────────────┘
        │  ULTRASONIC  │
        │   BONDING    │
        └──────┬───────┘

  S4 ◠  ┌──────────────┐
        │   THERMAL    │
        │   CURING     │
        └──────┬───────┘

  S5 ◠      ◇ O/S ◇ ───────→ NG
               │ OK

  S6 ◠  (   END   )
```

Fig .2A

Fig.2B

Fig.2C

Fig.2 D

## Fig.3A

## Fig.3B

## Fig.3C

Fig.4A

20

22

24

Fig.4B

20

22

24

Fig.4C

20

22

24

Fig.5A

Fig.5B

Fig.5C

Fig.6A

12
10

Fig.6B

34
12
10

Fig.6C

16
34
12
10

Fig.6D

40
36
34a
16
34
12
10

Fig.6E

40
36
16
16
34
12
10

Fig.6F

16
12
10

# Fig.7

S11 — START

CIRCUIT BOARD

S12 — RESIN FILM ADHESION

PROTRUDING ELECTRODE

S13 — ULTRASONIC BONDING

S14 — THERMAL CURING

S15 — O/S — NG

OK

S16 — END

Fig.8A

Fig.8B

Fig.8C

Fig.8D

Fig.8E

Fig.8F

## Fig.9A

## Fig.9B

## Fig.9C

Fig.10A

20
22 24
46
12
10

Fig.10B

28
26
20
22 24
32
46
12
30
10

Fig.10C

24 20
22
46
12
10

| INTERNATIONAL SEARCH REPORT | International application No. |
|---|---|
| | PCT/JP02/02255 |

**A. CLASSIFICATION OF SUBJECT MATTER**
Int.Cl$^7$ H01L21/60

According to International Patent Classification (IPC) or to both national classification and IPC

**B. FIELDS SEARCHED**

Minimum documentation searched (classification system followed by classification symbols)
Int.Cl$^7$ H01L21/60

Documentation searched other than minimum documentation to the extent that such documents are included in the fields searched
| Jitsuyo Shinan Koho | 1922–1996 | Jitsuyo Shinan Toroku Koho | 1996–2002 |
| Kokai Jitsuyo Shinan Koho | 1971–2002 | Toroku Jitsuyo Shinan Koho | 1994–2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 00/45430 A1 (Matsushita Electric Industrial Co., Ltd.), 03 August, 2000 (03.08.00), Page 63, lines 14 to 18; page 69, lines 4 to 9; page 71, line 4 to page 72, line 22; Figs. 38, 39, 43, 44, 57 & EP 1156520 A1 Column 58, lines 51 to 58; column 63, line 55 to column 64, line 7; column 65, line 47 to column 67, line 17; Figs. 38, 39, 43, 44, 57 | 1–5 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 May, 2002 (27.05.02) | 11 June, 2002 (11.06.02) |

| Name and mailing address of the ISA/ | Authorized officer |
|---|---|
| Japanese Patent Office | |
| Facsimile No. | Telephone No. |

Form PCT/ISA/210 (second sheet) (July 1998)